# EUROPEAN PATENT APPLICATION

(11) **EP 4 787 426 A1**
(43) Date of publication of application: **05.08.2026**
(21) Application number: 24871687.0
(22) Date of filing: 28.08.2024
(51) Int. Cl.: H01L 21/304, B24B 37/00, C09G 1/02, C09K 3/14

(54) **POLISHING COMPOSITION AND POLISHING METHOD**

(30) Priority: 25.09.2023 JP 2023160704
(71) Applicant: Fujimi Incorporated, Kiyosu-shi, Aichi 452-8502 (JP)
(72) Inventor: YAMAGUCHI, Hiroki, Kiyosu-shi, Aichi 452-8502 (JP); GOTO, Osamu, Kiyosu-shi, Aichi 452-8502 (JP)
(74) Representative: Grünecker Patent- und Rechtsanwälte PartG mbB
(86) International application number: PCT/JP2024/030754
(87) International publication number: WO 2025/069886

(57) **Abstract**

Provided is a polishing composition that is capable of maintaining low haze while achieving great defect reduction, with the composition including a cellulose derivative. The polishing composition provided contains a cellulose derivative and a basic compound. The cellulose derivative has a weight average molecular weight (Mw) of lower than 8×10⁴.

## Description

### [Technical Field]

The present invention relates to a polishing composition and a polishing method.

This application claims priority to Japanese Patent Application No. 2023-160704, filed on September 25, 2023; and the entire content thereof is herein incorporated by reference.

### [Background Art]

Precision polishing is performed on the surfaces of materials such as metals, semimetals, nonmetals and their oxides, using polishing compositions. For example, the surface of a silicon wafer used as a component of a semiconductor device is generally finished to a high-quality mirror surface through a lapping step (rough polishing step) and a polishing step (precision polishing step). The polishing step typically includes a stock polishing step and a final polishing step. Patent Documents 1 and 2 are exemplary technical references of a polishing composition mainly used for polishing semiconductor substrates such as silicon wafers.

### [Citation List]

### [Patent Literature]

[Patent Document 1] Japanese Patent Application Publication No. 2021-95431
[Patent Document 2] Japanese Patent Application Publication No. 2011-61089

### [Summary of Invention]

### [Technical Problem]

Polishing compositions used for polishing semiconductor substrates such as silicon wafers (e.g., polishing compositions used in the final polishing step) are required to have the ability to achieve a surface with low haze and few surface defects after polishing. Such polishing compositions may include, in addition to water, a water-soluble polymer for protecting the surface of the object to be polished, increasing the surface wettability, etc. In particular, cellulose derivatives are commonly used as water-soluble polymers.

While being useful as components to improve surface quality in polishing compositions, because cellulose derivatives are made from the natural product cellulose, their quality tends to be inconsistent. Thus, in cellulose derivative-containing polishing compositions, micro-agglomeration may occur, possibly causing surface defects. In addition, common cellulose derivatives have relatively high molecular weights. For instance, Patent Document 1 describes hydroxyethyl cellulose (HEC), a conventional cellulose derivative, having a weight average molecular weight (Mw) of 25×10⁴. In polishing compositions containing cellulose derivatives such as the above, the use of surfactants to improve the dispersibility of the cellulose derivatives and agglomerate removal by filtration are commonplace.

While cellulose derivatives with relatively high molecular weights are advantageous in protecting the surface being polished, they tend to have poor permeability to filters with small pore sizes, limiting the removal of agglomerates, etc. For instance, according to Patent Document 1, an HEC with Mw = 12×10⁴ and a specific surfactant are used together to improve the filterability of polishing compositions and reduce defects.

Patent Document 2 describes polishing compositions containing HEC hydrolysates (Mw = 8×10⁴, 33×10⁴, 53×10⁴, or 107×10⁴) prepared by hydrolysis of HEC (Mw = 30×10⁴ to 300×10⁴). Patent Document 2 also describes how the low-crystalline portions of HEC are preferentially hydrolyzed, selectively exposing the sites on the molecular surface that interact with silicon wafers, thereby bringing about good wettability to the silicon wafer surface during polishing and reducing wafer surface residues that could cause surface defects during rinsing (Paragraph 0011).

As described above, in the related art, there have been occasional studies on HEC with molecular weight lower than that commonly used; however, in practice, studies on low-molecular weight HEC have been limited to the Mw range of 8×10⁴ or higher as described in Patent Document 2. This is because HEC with Mw of 28×10⁴ and 9×10⁴ can equivalently inhibit agglomeration and reduce defects (e.g., compare the results of undermentioned Comparative Examples 2 and 4) and also because of the polishing effects (higher polishing removal rate, reduced haze, etc.) based on molecular weight.

Every year, there is an increase in demand for surface quality after polishing. As for surface defects, a greater degree of defect reduction is needed than ever before. It is desirable to achieve such a high level of defect reduction by adding a cellulose derivative without relying on other additives such as surfactants, as this would increase the freedom in designing polishing compositions. Against this technical background, the present inventors have conducted extensive research and successfully obtained a polishing composition capable of maintaining low haze while greatly reducing defects by using a previously unexamined low-Mw cellulose derivative, thereby completing the present invention. In particular, the present invention aims to provide a polishing composition capable of maintaining low haze while greatly reducing defects with the composition including a cellulose derivative, and a polishing method using the polishing composition.

### [Solution to Problem]

This description provides a polishing composition containing a cellulose derivative and a basic compound. The cellulose derivative has a weight average molecular weight (Mw) of below 8×10⁴. With the polishing composition, while maintaining low haze, defects can be greatly reduced.

In some embodiments, the cellulose derivative has a weight average molecular weight of 4000 or higher and below 8×10⁴. By using a cellulose derivative having a Mw in this range, the art disclosed herein is preferably implemented.

In some embodiments, the polishing composition further contains an abrasive. The abrasive-containing polishing composition helps obtain a good polishing removal rate. The art disclosed herein can greatly reduce defects in the abrasive-containing embodiment. In particular, the abrasive is preferably colloidal silica having an average primary particle diameter of 20 nm or greater and 50 nm or less. While no particular limitations are imposed, colloidal silica having such an average primary particle diameter is suitable for use in compositions for final polishing of semiconductor substrates such as silicon wafers.

The polishing composition disclosed herein can be preferably used for polishing a surface formed of a silicon material. By polishing a surface formed of a silicon material with the polishing composition, it is possible to achieve a high-quality silicon material surface with greatly reduced defects.

The polishing composition disclosed herein may be a concentrated liquid. The polishing composition disclosed herein may be produced, distributed, and stored in a concentrated liquid form.

In some embodiments, a polishing method is provided, the method including a step of polishing a surface formed of a silicon material, using the polishing composition. The polishing method can achieve a high-quality silicon material surface with very few defects.

This description also provides a rinse composition containing a cellulose derivative. The cellulose derivative has a weight average molecular weight (Mw) of below 8×10⁴. The rinse composition can be used, for instance, in a rinsing step after polishing.

### [Description of Embodiments]

Preferred embodiments of the present invention will be described below. Matters other than those particularly mentioned herein but are necessary for implementation of the present invention can be understood as design matters for those skilled in the art based on conventional technologies in the pertaining field. The present invention can be implemented based on the contents disclosed herein and common technical knowledge in the field.

### <Cellulose Derivative (A)>

The polishing composition disclosed herein includes a cellulose derivative (or cellulose derivative (A) hereinafter) having a weight average molecular weight (Mw) of below 8×10⁴. Here, cellulose derivatives are compounds in which some of the hydroxyl groups of cellulose are replaced with other substituents. Specifically, cellulose derivatives have β-glucose units as the main repeating unit. By using a cellulose derivative, low haze values can be obtained. With the use of a cellulose derivative with Mw < 8×10⁴, defects can be reduced greatly while maintaining low haze values. Furthermore, the polishing composition that includes a cellulose derivative with low Mw exhibits good and efficient filterability even through filters with small pore sizes. Thus, for instance, by using filters with small pore sizes, defect-causing agglomerates can be sufficiently removed. With the polishing composition with good filterability, filter clogging can be suppressed, improving the filter life.

Specific examples of the material cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. For the cellulose derivative, solely one kind or a combination of two or more kinds can be used. Among them, in view of improving the surface quality after polishing, hydroxyethyl cellulose (HEC) can be preferably used as the cellulose derivative.

The cellulose derivative (A) has a Mw of below 8×10⁴ (specifically, below 80,000). In view of reducing defects, in some embodiments, it can be 70,000 or lower, 60,000 or lower, or 50,000 or lower. In some preferable embodiments, the cellulose derivative (A) has a Mw of below 50,000, more preferably 40,000 or lower, yet more preferably 30,000 or lower, even more preferably 20,000 or lower, or particularly preferably 10,000 or lower (e.g., below 10,000, more specifically 9,000 or lower). Polishing compositions containing cellulose derivatives with Mw limited within these ranges can exhibit efficient filterability even when filters with small pore sizes are used and can remove potentially defect-causing agglomerates to a greater degree to achieve good defect reduction. The minimum Mw of the cellulose derivative (A) is not particularly limited. In view of protecting the surface being polished and improving the polishing ability, in some embodiments, it can be 1,000 or higher, 2,000 or higher, 4,000 or higher, 5,000 or higher, or 6,000 or higher. In other embodiments, the cellulose derivative (A) can have a Mw of 10,000 or higher (e.g., above 10,000), 15,000 or higher, or 30,000 or higher.

As the Mw of the cellulose derivative (A) herein, a value based on gel permeation chromatography (GPC) (aqueous phase, based on standard polyethylene oxides) can be used. As the GPC system, model name HLC-8320GPC available from Tosoh Corporation can be used. The analysis conditions can be as follows. The same method is also employed in the working examples described later.

### [GPC Analysis Conditions]

Sample concentration: 0.1 % by weight (wt%)
Column: TSKgel GMPWXL
Detector: differential refractometer
Eluent: 0.1 mol/L aqueous NaNO₃ solution
Flow rate: 1.0 mL/min
Measurement temperature: 40 °C
Injection volume: 200 µL

For instance, the cellulose derivative (A) may be synthesized by a known or conventional method, or may be obtained by reducing the Mw of a relatively high Mw cellulose derivative using a suitable method and conditions selected among known or conventional Mw reduction methods. In some cases, it may be preferable to obtain a cellulose derivative by the Mw reduction. For instance, a commercially-available cellulose derivative can be subjected to one or more Mw reduction treatments selected among pressure decomposition, thermal decomposition, shear treatment, enzymatic decomposition, electrolysis, radiolysis and so on under appropriate conditions (treatment time, etc.) to obtain a cellulose derivative (A) with the desired Mw.

### <Basic Compound>

The polishing composition disclosed herein includes a basic compound. As used herein, the term basic compound refers to a compound that dissolves in water and increases the pH of the aqueous solution. With the basic compound in the polishing composition, by its chemical polishing action (alkali etching), the object to be polished can be efficiently polished. Possible basic compounds include nitrogen-containing (N-containing) organic or inorganic basic compounds, hydroxides of alkali metals, hydroxides of alkaline earth metals, quaternary phosphonium compounds, and various carbonates or hydrogen carbonates. Examples of the N-containing basic compounds include quaternary ammonium compounds, ammonia and amines (preferably, water-soluble amines). These basic compounds can be used singly or in combination of two or more kinds thereof.

Among these basic compounds, it is preferable to use at least one kind of basic compound selected among, for instance, alkali metal hydroxides, quaternary ammonium hydroxides, or ammonia. In particular, potassium hydroxide, tetraalkyl ammonium hydroxide (e.g., tetramethylammonium hydroxide) or ammonia are more preferable, with ammonia being especially preferable.

### <Water>

The polishing composition disclosed herein typically includes water. Preferable examples of the water in the polishing composition include ion-exchanged water (deionized water), pure water, ultrapure water, and distilled water. To maximally avoid inhibition of the activities of other components in the polishing composition, for instance, the total amount of transition metal ions in the water used is preferably 100 ppb or less. For example, the water purity can be increased by removal of impurity ions with ion-exchange resin, removal of contaminants with filters, distillation, etc. The polishing composition disclosed herein may further include an organic solvent that can mix uniformly with water (lower alcohol, lower ketone, etc.), as needed. The solvent in the polishing composition is preferably at least 90 vol% (% by volume) water, or more preferably at least 95 vol% water (e.g., 99 vol% to 100 vol%).

### <Abrasive>

In some embodiments, the polishing composition preferably includes an abrasive. The abrasive contributes to an increase in polishing removal rate by mechanically polishing the surface of an object to be polished. The abrasive is not particularly limited in material, properties, etc., and can be appropriately selected according to the purpose and the way of using the polishing composition. Examples of the abrasive include inorganic particles, organic particles, and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonates such as calcium carbonate and barium carbonate. Specific examples of organic particles include polymethylmethacrylate (PMMA) particles, poly(meth)acrylic acid particles (in which (meth)acrylic acid comprehensively refers to acrylic acid and methacrylic acid), and polyacrylonitrile particles. These abrasives can be used singly or in combination of two or more kinds.

As the abrasive, inorganic particles (in particular, particles formed of a metal or semimetal oxide) are preferable, and silica particles are especially preferable. In the polishing composition that can be used in polishing (e.g., final polishing) of objects having a silicon surface, such as silicon wafers (discussed later), it is particularly beneficial to employ silica particles as the abrasive. For instance, the art disclosed herein can be preferably implemented in an embodiment in which the abrasive essentially consists of silica particles. Here, "essentially" indicates that silica particles account for at least 95 wt% (preferably 98 wt% or more, more preferably 99 wt% or more, or may be 100 wt%) of the particles forming the abrasive.

Specific examples of the silica particles include colloidal silica, fumed silica, and precipitated silica. The silica particles can be used singly or in combination of two or more kinds thereof. Colloidal silica is particularly preferable because it helps obtain a polished surface with a good surface grade after polishing. Examples of the colloidal silica include colloidal silica prepared by ion exchange starting from water glass (sodium silicate) and alkoxide colloidal silica (colloidal silica produced by the hydrolysis and condensation reaction of alkoxysilane). As the colloidal silica, solely one species or a combination of two or more species can be used.

The silica particles are preferably formed of a silica having an absolute specific gravity of 1.5 or greater, more preferably 1.6 or greater, even more preferably 1.7 or greater. The maximum absolute specific gravity of the silica is not particularly limited. It is typically 2.3 or less, for instance, 2.2 or less. The absolute specific gravity of the silica particles can be a measurement value determined by a liquid substitution method using ethanol as the substitution liquid.

The average primary particle diameter of the abrasive (typically, silica particles, suitably colloidal silica) is not particularly limited. In view of the polishing removal rate, etc., it is preferably 5 nm or greater, more preferably 10 nm or greater. In view of obtaining good polishing results (e.g., haze reduction, defect removal, etc.), the average primary particle diameter is preferably 15 nm or greater, more preferably 20 nm or greater (e.g., greater than 20 nm), yet more preferably 25 nm or greater, even more preferably 28 nm or greater, particularly preferably 30 nm or greater, or possibly 32 nm or greater. In view of low scratches and the like, the average primary particle diameter of the abrasive is preferably 100 nm or less, more preferably 50 nm or less, even more preferably 45 nm or less. In view of helping to obtain a surface with lower haze, in some embodiments, the average primary particle diameter of the abrasive is preferably 43 nm or less, more preferably 40 nm or less (e.g., less than 40 nm), or may be less than 38 nm.

As used herein, the average primary particle diameter refers to the particle size (BET particle size) calculated from the specific surface area (BET value) determined by the BET method according to the formula: average primary particle diameter (nm) = 6000/(true density (g/cm³) × BET value (m²/g)). The specific surface area can be measured using, for instance, a surface area analyzer, product name FLOWSORB II 2300 available from Micromeritics Instrument Corporation.

The average secondary particle diameter of the abrasive (typically, silica particles) is not particularly limited. For instance, it can be appropriately selected in the range of about 15 nm to 300 nm. In view of increasing the polishing removal rate, the average secondary particle diameter is preferably 30 nm or greater, or more preferably 35 nm or greater. In some embodiments, the average secondary particle diameter may be, for instance, 40 nm or greater, 42 nm or greater, or preferably 44 nm or greater. In typical, the average secondary particle diameter may be 250 nm or less, preferably 200 nm or less, or more preferably 150 nm or less. In some preferred embodiments, the average secondary particle diameter is 120 nm or less, more preferably 100 nm or less, or even more preferably 70 nm or less.

As used herein, the average secondary particle diameter refers to the particle diameter (volume average particle diameter) determined by dynamic light scattering. For instance, the average secondary particle diameter of the abrasive can be determined by dynamic light scattering, using product name NANOTRAC UPA-UT151 available from Nikkiso Co., Ltd.

The shape (outer shape) of the abrasive (typically, silica particles) may be globular or non-globular. Specific examples of non-globular particles include peanut-shaped (i.e., peanut shell-shaped), cocoon-shaped, conpeito-shaped and rugby ball-shaped particles. For instance, it is preferable to use silica particles that are mostly peanut-shaped or cocoon-shaped.

While no particular limitations are imposed, the average length/width ratio (average aspect ratio) of the abrasive (typically, silica particles) is theoretically 1.0 or higher, preferably 1.05 or higher, more preferably 1.1 or higher, or may be 1.2 or higher. With increasing average aspect ratio, a higher polishing removal rate can be obtained. In view of reducing scratches, etc., the average aspect ratio of the abrasive (typically, silica particles) is preferably 3.0 or lower, more preferably 2.0 or lower, even more preferably 1.5 or lower, or may be 1.4 or lower.

The shape (outer shape) and average aspect ratio of the abrasive (typically, silica particles) can be obtained, for instance, by electron microscopy. For instance, in a particular procedure for determining the average aspect ratio, a scanning electron microscope (SEM) is used to draw the smallest rectangle circumscribing each particle image for a prescribed number (e.g., 200) of abrasive grains (polisher particles, typically silica particles) whose individual particle shapes can be recognized. Then, for the rectangle drawn for each particle image, the long side length (long diameter value) is divided by the short side length (short diameter value) to determine the length/width ratio (aspect ratio). The average aspect ratio can be obtained by taking the arithmetic average of the aspect ratios of the prescribed number of particles.

### <Optional Water-Soluble Polymer>

The polishing composition disclosed herein may include an optional water-soluble polymer besides the cellulose derivative (A), as far as the effect of the present invention is not significantly impaired. The kind of optional water-soluble polymer is not particularly limited. Possible ones have at least one functional group selected among cation, anion or nonion groups. The optional water-soluble polymer can have a hydroxy group, a carboxy group, an acyl group, an acyloxy group, a sulfo group, an amide group, a quaternary ammonium structure, a heterocycle structure, a vinyl structure, a polyoxyalkylene structure, etc.

Examples of the optional water-soluble polymer include cellulose derivatives with Mw ≥ 8×10⁴; starch derivatives; polymers containing an oxyalkylene unit such as copolymers of ethylene oxide (EO) and propylene oxide (PO); vinyl alcohol-based polymers; N-containing polymers such as polymers having an N-vinyl monomer unit, imine derivatives, and polymers having an N-(meth)acryloyl monomer unit; and polymers having a carboxylic acid (including an acid anhydride). Specific examples include pullulan, random copolymers and block copolymers of ethylene oxide (EO) and propylene oxide (PO), polyglycerol, polyvinyl alcohol (PVA), acetalized polyvinyl alcohol, butene diol polyvinyl alcohol, carboxylated polyvinyl alcohol, sulfonated polyvinyl alcohol, polyvinyl alcohol-polyvinylpyrrolidone graft copolymer, polyvinyl alcohol-polyvinylpyrrolidone random copolymer, polyvinyl alcohol polyethylene oxide graft copolymer, polyvinyl alcohol polyethylene oxide random copolymer, polyisoprene sulfonic acid, polyvinyl sulfonic acid, polyallyl sulfonic acid, polyisoamylene sulfonic acid, polystyrene sulfonate, polyacrylate, polyvinyl acetate, polyethylene glycol, polyvinyl imidazole, polyvinyl carbazole, polyvinyl pyrrolidone, polyvinyl acetamide, polyacryloylmorpholine, polyhydroxyethyl acrylamide, polyallylamine, glycidol-modified polyallylamine, methyldiallylamine-sulfur dioxide copolymer, polyvinyl caprolactam, polyvinyl piperidine, olefin-maleic acid (anhydride) copolymer, and styrene-maleic acid (anhydride) copolymer. In view of potentially improving the polishing ability when used in the polishing composition, the optional water-soluble polymer is preferably a vinyl alcohol-based polymer or a polymer that includes N-(meth)acryloyl monomer unit. As the optional water-soluble polymer, solely one species or a combination of two or more species can be used. For a simpler composition, the polishing composition disclosed herein may be free of an optional water-soluble polymer other than the cellulose derivative (A).

The weight average molecular weight (Mw) of the optional water-soluble polymer is not particularly limited. The optional water-soluble polymer can have a Mw of, for instance, about 200×10⁴ or lower, or about 150×10⁴ or lower. In view of ease of cleaning, etc., it can be about 100×10⁴ or lower, or about 50×10⁴ or lower. In view of protection of the surface being polished, it can be 0.5×10⁴ or higher, or 0.7×10⁴ or higher. In some embodiments, the Mw can be 1×10⁴ or higher, or 2×10⁴ or higher, for instance, 5×10⁴ or higher. The Mw of the optional water-soluble polymer, the weight average molecular weight (aqueous phase, based on standard polyethylene glycols) determined by GPC can be used. The GPC analysis conditions can be the same as those for the aforementioned cellulose derivative (A).

In an embodiment where the polishing composition includes an optional water-soluble polymer, the ratio of the optional water-soluble polymer to the total water-soluble polymer content of the polishing composition is suitably approximately 50 wt% or less (e.g., less than 50 wt%), or may be 30 wt% or less, less than 10 wt%, less than 3 wt%, or less than 1 wt%. The art disclosed herein may be preferably implemented in an embodiment where the polishing composition is essentially free of an optional water-soluble polymer.

### <Surfactant>

The polishing composition disclosed herein can include a surfactant or can be essentially free of a surfactant. In some embodiments, the polishing composition includes a surfactant. The surfactant in the polishing composition can increase the dispersibility of the water-soluble polymer therein to improve the filterability. The surfactant-containing composition can achieve further quality improvement (haze reduction, defect reduction, etc.) of the polished surface. The surfactant can be anionic, cationic, nonionic, or amphoteric. It is typically preferable to use an anionic or nonionic surfactant. In view of haze reduction, low foaming and ease of pH adjustment, a nonionic surfactant is more preferable. Examples of the nonionic surfactant include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenyl ether, polyoxyethylene alkyl amine, polyoxyalkylene alkyl glucoside, polyoxyethylene fatty acid ester, polyoxyethylene glyceryl ether fatty acid ester, and polyoxyethylene sorbitan fatty acid ester; and copolymers of several kinds of oxyalkylene (e.g., diblock copolymers, triblock copolymers, random copolymers, and alternating copolymers). As the surfactant, solely one species or a combination of two or more species can be used.

Specific examples of the nonionic surfactant include block copolymers of ethylene oxide (EO) and propylene oxide (PO) (diblock copolymers, PEO (polyethylene oxide)-PPO (polypropylene oxide)-PEO triblock copolymers, PPO-PEO-PPO triblock copolymers, etc.), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexylether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrated phenyl ether, polyoxyethylene laurylamine, polyoxyethylene stearylamine, polyoxyethylene oleylamine, polyoxyethylene methylglucoside, polyoxypropylene methylglucoside, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene castor wax, and ethylenediamine tetrapolyoxyethylene polyoxypropylene (poloxamine). Particularly preferable surfactants include block copolymers of EO and PO (in particular, PEO-PPO-PEO triblock copolymer), random copolymers of EO and PO, and polyoxyethylene alkyl ethers (e.g., polyoxyethylene decyl ether). A preferable polyoxyethylene alkyl ether has about 1 mole to 10 (e.g., about 3 to 8) moles of EO added.

The surfactant has a molecular weight of, for instance, below 5000. In view of reducing agglomerates of the cellulose derivative (A) or in view of filterability, cleanability, etc., it is preferably 4500 or lower, for instance, below 4000. In view of surfactant activity, the molecular weight of the surfactant is typically suitably 200 or higher. In view of haze reduction, it is preferably 250 or higher (e.g., 300 or higher). Preferable molecular weight ranges of the surfactant may also vary depending on the kind of surfactant. For instance, when using a polyoxyethylene alkyl ether as the surfactant, its molecular weight is, for instance, preferably below 2000, more preferably 1900 or lower (e.g., below 1800), yet more preferably 1500 or lower, or may be 1000 or lower (e.g., 500 or lower). For instance, when a block copolymer of EO and PO is used as the surfactant, it can have a weight-average molecular weight of, for instance, 500 or higher, 1000 or higher, 1500 or higher, 2000 or higher, or even 2500 or higher. The maximum weight average molecular weight is, for instance, below 5000, preferably 4500 or lower, or may be, for instance, below 4000, below 3800, or below 3500.

The molecular weight of the surfactant can be calculated from its chemical formula, or the weight average molecular weight determined by GPC (aqueous phase, based on standard polyethylene glycols) can be used. The GPC analysis conditions can be the same as those for the aforementioned cellulose derivative (A). For instance, in case of a polyoxyethylene alkyl ether, the molecular weight calculated from its chemical formula is preferably used. In case of an EO/PO block copolymer, the weight average molecular weight determined by GPC is preferably used.

The polishing composition disclosed herein can be brought about in an embodiment essentially free of a surfactant or has a limited surfactant content. While no particular limitations are imposed, in an embodiment essentially free of a surfactant or having a limited surfactant content, the amount of surfactant in the polishing composition relative to 100 parts by weight of the cellulose derivative (A) can be less than about 50 parts by weight, less than 30 parts by weight, less than 10 parts by weight, less than 3 parts by weight, less than 1.5 parts by weight, or less than 1 part by weight.

### <Other Components>

As long as the effect of this invention is not significantly impaired, the polishing composition disclosed herein may further include, as necessary, known additives that can be used in polishing compositions (e.g., polishing compositions used in final polishing steps of silicon wafers), such as organic acids, organic acid salts, inorganic acids, inorganic acid salts, chelating agents, antiseptic agents, and antifungal agents.

Among organic and inorganic acids and salts thereof, solely one species or a combination of two or more species can be used. Examples of organic acids include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris(methylenephosphoric acid) (NTMP); and organic phosphonic acid such as phosphonobutane tricarboxylic acid (PBTC). Examples of organic acid salts include alkali metal salts (sodium salts, potassium salts, lithium salts, etc.) and ammonium salts of organic acids. Examples of inorganic acids include hydrochloric acid, phosphoric acid, sulfuric acid, phosphonic acid, nitric acid, phosphinic acid, boric acid, and carbonic acid. Examples of inorganic acid salts include alkali metal salts (sodium salts, potassium salts, lithium salts, etc.) of inorganic acids.

As the chelating agent, solely one species or a combination of two or more species can be used. Examples of the chelating agent include aminocarboxylic acid-based chelating agents and organic phosphonic acid-based chelating agents. Favorable examples of chelating agents include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein is preferably essentially free of an oxidant. This is because when an oxidant-containing polishing composition is supplied to a substrate (e.g., a silicon wafer), it may oxidize the substrate surface and form an oxide layer, thereby reducing the polishing removal rate. Specific examples of the oxidant here include hydrogen peroxide (H₂O₂), sodium persulfate, ammonium persulfate, and sodium dichroloisocyanurate. The polishing composition being essentially free of an oxidant refers to at least no intentional inclusion of an oxidant. Thus, the concept of essentially oxidant-free polishing composition here can include a polishing composition that inevitably includes a trace amount of oxidant (e.g., a molar oxidant in polishing composition being 0.001 mol/L or less, preferably 0.0005 mol/L or less, more preferably 0.0001 mol/L or less, yet more preferably 0.00005 mol/L or less, particularly preferably 0.00001 mol/L or less) due to the starting materials, manufacturing process, etc.

### <pH>

The pH of the polishing composition disclosed herein is not particularly limited, and a suitable pH can be selected according to the substrate, etc. In some embodiments, the polishing composition has a pH of suitably 8.0 or higher, preferably 8.5 or higher, more preferably 9.0 or higher. With increasing pH of the polishing composition, the polishing removal rate tends to increase. Meanwhile, in view of preventing dissolution of silica particles and suppressing deterioration of mechanical polishing action, the polishing composition typically has a pH of suitably 12.0 or lower, preferably 11.0 or lower, more preferably 10.8 or lower, or even more preferably 10.5 or lower.

In the art disclosed herein, the pH of a polishing compound can be determined by using a pH meter, performing three-point calibration using standard buffer solutions, then placing the glass electrode in the composition to be measured and measuring the value after allowing it to stabilize for at least two minutes. As the pH meter, a glass-electrode pH meter (e.g., model F-72 available from Horiba, Ltd.) can be used. The standard buffer solutions used are phthalate pH buffer with pH 4.01 (25 °C), neutral phosphate pH buffer with pH 6.86 (25 °C), and carbonate pH buffer with pH 10.01 (25 °C)

### <Polishing Slurry>

The polishing composition disclosed herein is typically supplied to the substrate surface as a polishing slurry that includes the polishing composition, and used for polishing the substrate. For instance, the polishing slurry can be prepared by diluting a polishing composition disclosed herein (typically, with water). Alternatively, the polishing composition may be used as is as the polishing slurry. Other examples of the polishing slurry that includes the polishing composition disclosed herein include a polishing slurry obtained by adjusting the pH of the composition.

The amount of the cellulose derivative (A) in the polishing slurry is not particularly limited, and can be, for instance, 0.0001 wt% or greater. In view of haze reduction, etc., it is preferably 0.0005 wt% or greater, more preferably 0.001 wt% or greater, or yet more preferably 0.002 wt% or greater, for instance, 0.005 wt% or greater. In view of the polishing removal rate, etc., in some preferable embodiments, the amount of the cellulose derivative (A) may be 0.2 wt% or less, or it is more preferably 0.1 wt% or less, yet more preferably 0.05 wt% or less, even more preferably 0.02 wt% or less, further more preferably 0.015 wt% or less, particularly preferably 0.012 wt% or less, or may even be 0.010 wt% or less (e.g., below 0.010 wt%).

In an embodiment where the polishing composition includes an abrasive, the amount of the cellulose derivative (A) in the polishing composition can also be specified relative to the abrasive (typically silica particles). While no particular limitations are imposed, the cellulose derivative (A) content per 100 parts by weight of abrasive can be, for instance, 0.01 part by weight or greater, or suitably 0.1 part by weight or greater. In some preferable embodiments, in view of better utilizing the effects (defect reduction and haze reduction) of using the cellulose derivative (A), the cellulose derivative (A) content is 1 part by weight or greater, more preferably 3 parts by weight or greater, yet more preferably 5 parts by weight or greater, or may be 10 parts by weight or greater, 15 parts by weight or greater, or 20 parts by weight or greater. In some embodiments, the cellulose derivative (A) content per 100 parts by weight of abrasive is, for instance, 30 parts by weight or less, suitably 20 parts by weight or less, preferably 15 parts by weight or less, more preferably 10 parts by weight or less (e.g., below 10 parts by weight), or may be 9 parts by weight or less, or 8 parts by weight or less. By limiting the cellulose derivative (A) content, the polishing removal rate tends to increase.

The amount of basic compound in the polishing slurry is not particularly limited. In view of increasing the polishing removal rate, etc., in typical, it is suitably 0.00001 wt% or greater, preferably 0.00005 wt% or greater, more preferably 0.0001 wt% or greater, particularly preferably 0.0003 wt% or greater, or may be 0.0005 wt% or greater, 0.001 wt% or greater, or 0.005 wt% or greater. In view of improving the surface quality (e.g., haze reduction), etc., it is suitably below 0.1 wt%, preferably below 0.05 wt%, or more preferably below 0.03 wt% (e.g., below 0.025 wt%). In some preferable embodiments, it can be below 0.01 wt%, or below 0.008 wt%.

In an embodiment where the polishing slurry includes an abrasive (typically, silica particles), the abrasive content of the polishing slurry is not particularly limited. It is, for instance, 0.001 wt% or greater, preferably 0.05 wt% or greater, more preferably 0.10 wt% or greater. With increasing abrasive content, a higher polishing removal rate can be obtained. The abrasive content is suitably 10 wt% or less, preferably 7 wt% or less, more preferably 5 wt% or less, or even more preferably 2 wt% or less, for instance, 1 wt% or less. In some embodiments, it can be 0.75 wt% or less, 0.5 wt% or less (e.g., below 0.5 wt%), 0.25 wt% or less (e.g., below 0.25 wt%), or 0.2 wt% or less. The abrasive content limited within these ranges helps maintain surface quality.

When the polishing slurry includes a surfactant, the surfactant content of polishing slurry is not particularly limited. Typically, in view of increased dispersibility and ease of cleaning of the cellulose derivative (A), the surfactant content can be, for instance, 0.00001 wt% or greater. In view of haze reduction, etc., in some embodiments, it can be 0.0002 wt% or greater, 0.0003 wt% or greater, or 0.0005 wt% or greater. In view of the polishing removal rate, etc., it can be 0.1 wt% or less, 0.01 wt% or less, or 0.005 wt% or less (e.g., 0.002 wt% or less). In an embodiment where the polishing composition is essentially free of a surfactant or has a limited surfactant content, the amount of surfactant in the polishing slurry can be less than 0.001 wt%, less than 0.0001 wt%, or less than 0.00001 wt%.

### <Concentrated Liquid>

The polishing composition disclosed herein may be in a concentrated form (i.e., in the form of a polishing slurry concentrated liquid) before supplied to a substrate. Such concentrated polishing compositions are preferred in view of convenience and cost reduction during production, distribution, storage, etc. The concentration factor is not particularly limited. For instance, it can be about 2-fold to 100-fold in volume, and is usually suitably about 5-fold to 50-fold (e.g., about 10-fold to 40-fold). Such a concentrated liquid can be diluted when desired to prepare a polishing slurry (working slurry), which can then be used by supplying it to a substrate. The dilution can be performed by adding water to the concentrated liquid and mixing them, for instance.

When diluting the polishing composition (i.e., a concentrated liquid) for use in polishing, the amount of the cellulose derivative (A) in the concentrated liquid can be, for instance, 3 wt% or less. In view of the filterability and ease of cleaning of the polishing composition, the cellulose derivative (A) content is typically preferably 1 wt% or less, more preferably 0.5 wt% or less, or may be 0.3 wt% or less. In view of convenience and cost reduction during production, distribution, storage, etc., it is typically suitably 0.001 wt% or greater, preferably 0.005 wt% or greater, or more preferably 0.01 wt% or greater.

In some embodiments, the amount of basic compound in the concentrated liquid can be, for instance, less than 15 wt%. In view of storage stability, etc., the basic compound content is typically preferably 0.7 wt% or less, more preferably 0.4 wt% or less, or may be 0.1 wt% or less, or 0.05 wt% or less. In view of convenience and cost reduction during production, distribution, storage, etc., it can also be, for instance, 0.005 wt% or greater, preferably 0.01 wt% or greater, more preferably 0.02 wt% or greater, or may be 0.05 wt% or greater.

In an embodiment where the concentrated liquid includes an abrasive (typically, silica particles, the abrasive content of the concentrated liquid can be, for instance, 25 wt% or less. In view of dispersion stability and filterability of the polishing composition, the abrasive content is typically preferably 20 wt% or less, or more preferably 15 wt% or less. In some preferred embodiments, the abrasive content may be 10 wt% or less, or 5 wt% or less (e.g., below 5 wt%). In view of convenience and cost reduction during production, distribution, storage, etc., the abrasive content of the concentrated liquid can be, for instance, 0.1 wt% or greater, and is preferably 0.5 wt% or greater, more preferably 0.7 wt% or greater, or even more preferably 1 wt% or greater.

In an embodiment where the concentrated liquid includes a surfactant, the surfactant content of the concentrated liquid can be, for instance, 0.25 wt% or less, preferably 0.15 wt% or less, more preferably 0.1 wt% or less, or may be 0.05 wt% or less, or 0.025 wt% or less. The surfactant content of the concentrated liquid can also be, for instance, 0.0001 wt% or greater, preferably 0.001 wt% or greater, more preferably 0.005 wt% or greater, or even more preferably 0.01 wt% or greater. In an embodiment where the polishing composition is essentially free of a surfactant or has a limited surfactant content, the surfactant content of the concentrated liquid can be below 0.01 wt%, below 0.005 wt%, or below 0.001 wt%.

### <Preparation of Polishing Composition>

The polishing composition used in the art disclosed herein may be a single-agent type or a multi-agent type such as a two-agent type. For instance, the polishing composition may be configured to prepare a polishing slurry by mixing Part A and Part B and diluting the mixture as needed when appropriate, with Part A including at least the abrasive among its components and Part B including at least some of the remaining components. Parts A and B may have undergone one, two or more filtrations, or may be unfiltered.

The method for preparing the polishing composition is not particularly limited. For instance, the respective components of the polishing composition can be mixed, using a known mixing device such as a blade stirrer, ultrasonic disperser, or homomixer. The embodiment of mixing these components is not particularly limited. For instance, all the components may be mixed at once or in a predetermined suitable order. After mixing, one, two or more filtrations may be performed, or filtrations may not be performed.

In some embodiments, it is preferable to use the polishing composition for polishing substrates after filtration with a filter. The filter structure is not particularly limited. For instance, a membrane filter having a porous membrane layer is preferably used. A filter having a filter fiber layer formed of filter fibers may also be used. Examples of the filter with a filter fiber layer include a woven fabric filter (mesh filter). The shape of the filter medium is not particularly limited. Depth filters, surface filters, pleated depth filters (depth filters with pleats), and pleated filters (surface filters with pleats) can be used. Among them, pleated filters are preferable in view of facilitating filtration of the liquid being filtered.

While no particular limitations are imposed, in some embodiments, it is preferable to use a filter having an average pore size of 0.15 µm or smaller, determined by a palm porometer. The polishing composition disclosed herein is highly filterable. Thus, it can be filtered efficiently even when using a filter with the prescribed average pore size or smaller, and defect-causing agglomerates can be more effectively removed. In some preferred embodiments, the filter used can have an average pore size of 0.14 µm or smaller, more preferably 0.12 µm or smaller, yet more preferably 0.10 µm or smaller, particularly preferably 0.08 µm or smaller, or may be 0.06 µm or smaller. In view of liquid permeability, etc., the minimum average pore size can be, for instance, 0.01 µm or larger, or 0.03 µm or larger.

As the average pore size of a filter here, the D50 pore size is used, corresponding to the 50th-percentile value in the micropore size distribution obtained by measurement based on the half-dry method in accordance with ASTM E1294-89. For instance, a palm porometer (CFP-1200AXL) available from Porous Materials, Inc. can be used for the measurement. This measurement method is used in the working examples described later.

Filtration conditions (e.g., filtration differential pressure, filtration rate, and filtration volume) may be set appropriately based on common technical knowledge in this field, taking into account the target quality, production efficiency, etc. The filtration method is not particularly limited. For instance, a known filtration method can be suitably used, such as natural filtration at atmospheric pressure, suction filtration, pressure filtration, and centrifugal filtration. Before or after the filtration, additional filtrations may be optionally performed, either preliminarily or in multiple stages, depending on the purpose, such as the removal of coarse particles or high-precision filtration.

### <Applications>

The polishing composition disclosed herein can be applied to polish substrates of various materials and shapes. For instance, the substrate material can be a metal or semimetal such as silicon material, aluminum, nickel, tungsten, copper, tantalum, titanium and stainless steel, or an alloy thereof; a glassy substance such as quartz glass, aluminosilicate glass, and glassy carbon; a ceramic material such as alumina, silica, sapphire, silicon nitride, tantalum nitride, and titanium carbide; a compound semiconductor substrate material such as silicon carbide, gallium nitride, and gallium arsenide; and a resin materials such as polyimide resin. The substrate may be formed of several materials among these. The substrate shape is not particularly limited. The polishing composition disclosed herein can be used in polishing a substrate with a flat surface or polishing a substrate edge (e.g., a wafer edge).

The polishing composition disclosed herein can be particularly preferably used for polishing a surface formed of a silicon material (typically, for polishing a silicon wafer). Specific examples of the silicon material include single silicon crystal, amorphous silicon, and polysilicon. The polishing composition disclosed herein can be particularly preferably used for polishing a surface formed of single silicon crystal (e.g., for polishing a silicon wafer).

The polishing composition disclosed herein can be preferably applied to a step of polishing a substrate (e.g., a silicon wafer). Before the polishing step with the polishing composition disclosed herein, the substrate may be subjected to a general treatment applicable to the substrate in a step upstream of the polishing step, such as lapping or etching.

The polishing composition disclosed herein is effective when used in the final polishing step of a substrate (e.g., a silicon wafer) or in the polishing step immediately preceding it. It is particularly preferable for use in the final polishing step. The final polishing step here refers to the last polishing step (i.e., the step followed by no further polishing) in a manufacturing process of objects of interest. The polishing composition disclosed herein may also be used in a polishing step upstream of the final polishing (the upstream step referring to a stock polishing step between the rough polishing step and the last polishing step, typically including at least a primary polishing step, and may further include a secondary, tertiary, etc. polishing steps). For instance, it can be used in a polishing step performed immediately before final polishing.

The polishing composition disclosed herein is effectively used, for instance, in polishing (typically, final polishing or polishing just before that) a silicon wafer adjusted to a surface roughness of 0.01 nm to 100 nm in an upstream step. It is particularly preferable for final polishing. The surface roughness Ra of a substrate can be measured using, for instance, laser scanning surface roughness meter TMS-3000WRC available from Schmitt Measurement System Inc.

### <Polishing>

The polishing composition disclosed herein can be used for polishing a substrate, for instance, in an embodiment including the following operation. Described next is a preferable embodiment of the method for polishing a silicon wafer as the substrate, using the polishing composition disclosed herein.

In other words, a polishing slurry is obtained, including a polishing composition disclosed herein. Obtaining the polishing slurry may include preparing the polishing slurry by subjecting the polishing composition to concentration adjustment (e.g., dilution), pH adjustment, etc. Alternatively, the polishing composition may be used as is as a polishing slurry.

Subsequently, the polishing slurry is supplied to a substrate, and polishing is carried out by a common method. For example, in final polishing of a silicon wafer, the silicon wafer that has undergone a lapping step is typically set in a general polishing machine, and then the polishing slurry is supplied through the polishing pad of the polishing machine to the silicon wafer surface to be polished. Typically, while the polishing slurry is continuously supplied, the polishing pad is pushed against the silicon wafer surface to be polished and both are moved (rotated) relative to each other. Through such a polishing step, the substrate is completely polished.

The polishing pad used in the polishing step is not particularly limited. The polishing pad can be of, for instance, foamed polyurethane, nonwoven fabric, suede, etc. Each polishing pad may or may not include an abrasive. Usually, abrasive-free polishing pads are preferably used.

### <Rinse>

The substrate (e.g., a silicon wafer) polished with the polishing composition can be rinsed with a rinse solution including the same components as the polishing composition excluding the abrasive if any. In other words, the art disclosed herein may include a rinsing step, a step of rinsing the substrate (e.g., a silicon wafer) with a rinse solution including the same components as the polishing composition excluding the abrasive if any. The rinsing step can reduce residues such as abrasives that cause defects and haze on the surface of the substrate (e.g., a silicon wafer). The rinsing step may be performed between polishing steps, or after the final polishing step and before the cleaning step described below. Such a rinse solution may typically be a rinse composition including a cellulose derivative with Mw < 8×10⁴ (e.g., a composition used to rinse silicon wafers). By using the rinse composition that includes the cellulose derivative with Mw < 8×10⁴, a substrate (e.g., a silicon wafer) polished with a polishing composition disclosed herein can be suitably rinsed. The rinse composition can have the same composition as the aforementioned polishing composition excluding the abrasive if any. Thus, the details will not be repeated here.

### <Cleaning>

The substrate polished with the polishing composition disclosed herein is typically cleaned. Cleaning can be performed using a suitable cleaning solution. The cleaning solution used is not particularly limited. For instance, it is possible to use SC-1 cleaning solution (a mixture of ammonium hydroxide (NH₄OH), hydrogen peroxide (H₂O₂) and water (H₂O)), SC-2 cleaning solution (a mixture of HCl, H₂O₂, and H₂O), ozone water cleaning solution, hydrofluoric acid cleaning solution, etc., which are common in the semiconductor industry. The temperature of the cleaning solution can be within the range of room temperature (typically, about 15 °C to 25 °C) or higher to about 90 °C. In view of improving the cleaning effect, a cleaning solution at about 50 °C to 85 °C can be preferably used.

As mentioned above, the art disclosed herein may also provide a method for producing a polished material, the method including a polishing step by an aforementioned polishing method (e.g., a method for producing a silicon wafer); and a polished material (e.g., a silicon wafer) produced by the method.

The matters disclosed herein include the following:
(1) A polishing composition containing a cellulose derivative and a basic compound,
   wherein the cellulose derivative has a weight average molecular weight of below 8×10⁴.
(2) The polishing composition according to (1) above, wherein the cellulose derivative has a weight average molecular weight of 4000 or higher and below 8×10⁴.
(3) The polishing composition according to (1) or (2) above, further containing an abrasive.
(4) The polishing composition according to (3) above, wherein the abrasive is colloidal silica having an average primary particle diameter of 20 nm or greater and 50 nm or less.
(5) The polishing composition according to any of (1) to (4) above, in use for polishing a surface formed of a silicon material.
(6) A concentrated liquid of the polishing composition according to any of (1) to (5) above.
(7) A polishing method including a step of polishing a surface formed of a silicon material, using the polishing composition according to any of (1) to (5) above.
(8) A rinse composition containing a cellulose derivative, wherein the cellulose derivative has a weight average molecular weight of below 8×10⁴.

### [Examples]

Several examples relating to the present invention will be described below, but the present invention is not to be limited to the embodiments shown in the examples. In the following description, "part" and "%" are by weight unless otherwise specified.

### «Experiment 1»

### <Preparation of Polishing Composition Concentrated Liquid>

### (Examples 1 to 2 and Comparative Example 1)

Were mixed an abrasive, hydroxyethyl cellulose (HEC), ammonia and deionized water to prepare a polishing composition concentrated liquid according to each example. As the abrasive, was used colloidal silica with an average primary particle diameter of 35 nm. As the HEC, was used an HEC having the Mw shown in Table 1.

### <Filtration>

The polishing composition concentrated liquid according to each example was filtered under the conditions shown below.

### [Filtration Conditions]

Suction pump: oil-free pump PSH028AA
Filter holder: KP-47H 47 mm polysulfone holder
Decompression vessel: VT-500
Filtration differential pressure: 80 kPa
Filter: 0.145 µm average pore size, 47 mm filter diameter

### <Preparation of Polishing Composition>

The filtered polishing composition concentrated liquid was diluted 20-fold by volume with deionized water to obtain a polishing composition with 0.5 % abrasive, 0.1 % HEC and 0.01 % ammonia according to each example.

### <Evaluation of Polished Surface Quality>

### (Silicon Wafer Polishing)

Under Polishing condition 1, was stock-polished a lapped and etched commercially available silicon single crystal wafer (P-type conductivity, <100> crystal orientation, free of COP (crystal originated particles, i.e., crystal defects)) with a diameter of 300 mm to obtain a silicon wafer as the substrate. The stock polishing was performed using a polishing slurry with 0.6 % abrasive (colloidal silica with an average primary particle diameter of 35 nm) and 0.08 % tetramethylammonium hydroxide (TMAH) in deionized water.

### [Polishing Condition 1]

Polishing machine: a single wafer polishing machine, model PNX-332B, manufactured by Okamoto Machine Tool Works, Ltd.
Polishing pressure: 20 kPa
Platen rotational speed: 20 rpm
Head (carrier) rotational speed: 20 rpm
Polishing pad: product name SUBA400 manufactured by Nitta Dupont Inc.
Supply flow rate of polishing slurry: 1.0 L/min
Polishing slurry temperature: 20 °C
Platen cooling water temperature: 20 °C
Polishing time: 2 minutes

Using the polishing composition according to each example as the polishing slurry, the silicon wafer after stock polishing was polished under Polishing condition 2 and consecutively under Polishing condition 3 shown below.

### [Polishing Condition 2]

Polishing machine: a single wafer polishing machine, model PNX-332B, manufactured by Okamoto Machine Tool Works, Ltd.
Polishing pressure: 16 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 minutes

### [Polishing Condition 3]

Polishing machine: a single wafer polishing machine, model PNX-332B, manufactured by Okamoto Machine Tool Works, Ltd.
Polishing pressure: 20 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 minutes

Were obtained a first cleaning bath having a cleaning solution with NH₄OH (29 %)/H₂O₂ (31 %)/deionized water = 2/5.3/48 (volume ratio) maintained at 70 °C, and a second cleaning bath having ultrapure water at 25 °C. The polished silicon wafer was immersed in the first cleaning bath for 6 minutes and in the second cleaning bath for 40 minutes, again in the first cleaning bath for 6 minutes and in the second cleaning bath for 4 minutes, and then was dried.

### <Defect Analysis>

With respect to the cleaned silicon wafer surface, the number of defects (LPD and LPD-N combined) was analyzed in DC mode using a wafer surface tester (product name SURFSCAN SP5 available from KLA-Tencor Corporation). The results were converted into relative values with the number of defects in Comparative Example 1 being 100 %. The resulting values are shown in the corresponding column in Table 1.

### <Haze Analysis>

With respect to the cleaned silicon wafer surface, the haze (ppm) was measured in DW2O mode using a wafer surface tester (product name SURFSCAN SP5 available from KLA-Tencor Corporation). The results were converted into relative values with the haze value in Comparative Example 1 being 100 %. The resulting values are shown in the corresponding column in Table 1.

### «Experiment 2»

### <Preparation of Polishing Composition Concentrated Liquid>

### (Examples 3 to 7 and Comparative Examples 2 to 4)

Were mixed an abrasive, an HEC (with Mw shown in Table 2), ammonia and deionized water to prepare a polishing composition concentrated liquid according to each example. In Comparative Example 2, was also mixed polyoxyethylene decyl ether (C10PEO5) as a surfactant to prepare a polishing composition concentrated liquid.

### <Filtration>

Using a filter having the average pore size shown in Table2, but otherwise under the same conditions as Experiment 1, was filtered the polishing composition concentrated liquid according to each example.

### < Preparation of Polishing Composition >

The filtered polishing composition concentrated liquid was diluted 40-fold by volume with deionized water to obtain a polishing composition with 0.12 % abrasive, 0.009 % HEC and 0.005 % ammonia according to each example. The polishing composition according to Comparative Example 2 had 0.0004 % surfactant.

### <Evaluation of Polished Surface Quality>

### (Silicon Wafer Polishing)

Under Polishing condition 1, was stock-polished a lapped and etched commercially available silicon single crystal wafer (P-type conductivity, <100> crystal orientation, free of COP (crystal originated particles, i.e., crystal defects)) with a diameter of 300 mm to obtain a silicon wafer as the substrate. The stock polishing was performed using a polishing slurry with 1.0 % abrasive (colloidal silica with an average primary particle diameter of 35 nm) and 0.068 % potassium hydroxide in deionized water.

### [Polishing Condition 1]

Polishing machine: a single wafer polishing machine, model PNX-332B, manufactured by Okamoto Machine Tool Works, Ltd.
Polishing pressure: 12 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.0 L/min
Polishing slurry temperature: 20 °C
Platen cooling water temperature: 20 °C
Polishing time: 4 minutes

Using the polishing composition according to each example as the polishing slurry, the silicon wafer after stock polishing was polished under Polishing condition 2 and consecutively under Polishing condition 3 shown below.

### [Polishing Conditions 2 and 3]

Polishing machine: a single wafer polishing machine, model PNX-332B, manufactured by Okamoto Machine Tool Works, Ltd.
Polishing pressure: 12 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 2.0 L/min
Polishing slurry temperature: 20 °C
Platen cooling water temperature: 20 °C
Polishing time: 4 minutes

The polished silicon wafer was removed from the polishing machine and subjected to a total of three sets of cleaning processes, with one set consisting of cleaning with an ozone water cleaning solution (60 seconds) followed by cleaning with SC-1 cleaning solution and a brush (110 seconds) followed by cleaning with an ozone water cleaning solution (20 seconds) and cleaning with a hydrofluoric acid cleaning solution (15 seconds); and it was further cleaned with an ozone water cleaning solution (20 seconds), and then dried.

### <Defect and Haze Measurement>

By the methods according to Experiment 1, defects and haze were analyzed. The results were converted into relative values with the number of defects and the haze value in Comparative Example 3 being 100 %. The resulting values are shown in the corresponding columns in Table 2. With a haze value of 110 or lower, it is determined that the haze value is maintained low.

### <Evaluation of Filterability (for both Experiments 1 and 2)>

The polishing composition concentrated liquid according to each example was diluted with deionized water to 1.3 % HEC to obtain an evaluation sample. As a reference, deionized water was obtained. The respective containers with the evaluation sample and the reference (deionized water) were stored in an air bath at 25 °C. The filter used for filterability evaluation was washed with approximately 10 mL of deionized water. Subsequently, under the filtration conditions of Experiment 1, the filtration time was measured for 50 g of the reference and then for 50 g of the evaluation sample in this order. The filtration index was determined as the filtration time ratio, which is the ratio of the evaluation sample's filtration time to the reference's filtration time. This procedure was performed for each example to obtain a filtration index for each example. The results (filtration indices) were converted into relative values, with the filtration index for Comparative Example 2 being 100 %. The resulting values are shown in the appropriate columns in Tables 1 and 2. For filtration not completed within a predetermined time, "Incomplete" is noted.

### [Table 1]

**Table 1**

| | HEC | | Filter | Filterability (%) | Defects (%) | Haze (%) |
|---|---|---|---|---|---|---|
| | Mw | Amount (%) | Average pore size (µm) | | | |
| Ex. 1 | 2.0×10⁴ | | | 36 | 45 | 92 |
| Ex. 2 | 5.0×10⁴ | 0.1 | 0.145 | 47 | 78 | 92 |
| Comp. Ex. 1 | 2.8×10⁵ | | | Incomplete | 100 | 100 |

### [Table 2]

**Table 2**

| | HEC | | Surfactant | Filter | Filterability (%) | Defects (%) | Haze (%) |
|---|---|---|---|---|---|---|---|
| | Mw | Amount (%) | | Average pore size (µm) | | | |
| Ex. 3 | 0.7×10⁴ | | - | 0.145 | 7 | 7 | 103 |
| Ex. 4 | 0.7×10⁴ | | - | 0.118 | 7 | 7 | 109 |
| Ex. 5 | 0.7×10⁴ | | - | 0.090 | 7 | 4 | 110 |
| Ex. 6 | 0.7×10⁴ | 0.009 | - | 0.044 | 7 | 4 | 109 |
| Ex. 7 | 7.9×10⁴ | | - | 0.118 | 53 | 7 | 100 |
| Comp. Ex. 2 | 2.8×10⁵ | | Present | 0.118 | 100 | 8 | 95 |
| Comp. Ex. 3 | 2.8×10⁵ | | - | 0.145 | Incomplete | 100 | 100 |
| Comp. Ex. 4 | 9.0×10⁴ | | - | 0.118 | 16 | 12 | 98 |

As shown in Table 1, in Experiment 1, the polishing compositions of Examples 1 and 2 including HEC with Mw < 8×10⁴ resulted in lower haze values, with a reduction in defects by 22 % based on the relative values, compared to Comparative Example 1 using an HEC with Mw ≥ 8×10⁴. Especially, Example 1 using an HEC with Mw = 2× 10⁴ brought about good defect reduction. The polishing compositions of Examples 1 and 2 also showed good filterability. In Experiment 2, as shown in Table 2, the polishing compositions of Examples 3 to 7 using HEC with Mw < 8×10⁴ showed good defect reduction as in Experiment 1, compared to Comparative Examples 3 and 4 using HEC with Mw = 9×10⁴ and Mw = 28×10⁴. Comparing Comparative Examples 2 and 3, the use of HEC with Mw = 28×10⁴ in combination with a surfactant improved the filterability and reduced the number of defects. Nevertheless, it was still not as effective as Examples 3 to 7 in reducing defects. As for Examples 3 to 6 in which the polishing compositions including HEC with Mw = 0.7×10⁴ were filtered with filters varying in pore size and then evaluated, their results indicate that a low-Mw HEC-containing polishing composition shows good filterability through filters with small pore sizes, enabling greater defect reduction.

Although specific embodiments of the present invention have been described in detail above, these are merely for illustrations and do not limit the scope of claims. The art according to the claims includes various modifications and changes made to the specific embodiments illustrated above.

## Claims

1. A polishing composition containing a cellulose derivative and a basic compound,
wherein the cellulose derivative has a weight average molecular weight of below 8×10⁴.

2. The polishing composition according to Claim 1, wherein the cellulose derivative has the weight average molecular weight of 4000 or higher and below 8×10⁴.

3. The polishing composition according to Claim 1 or 2, further containing an abrasive.

4. The polishing composition according to Claim 3, wherein the abrasive is colloidal silica having an average primary particle diameter of 20 nm or greater and 50 nm or less.

5. The polishing composition according to Claim 1 or 2 in use for polishing a surface formed of a silicon material.

6. A concentrated liquid of the polishing composition according to Claim 1 or 2.

7. A polishing method comprising a step of polishing a surface formed of a silicon material, using the polishing composition according to Claim 1 or 2.

8. A rinse composition containing a cellulose derivative, wherein the cellulose derivative has a weight average molecular weight of below 8×10⁴.
